# EUROPEAN PATENT APPLICATION

(11) **EP 2 402 768 A2**
(43) Date of publication of application: **04.01.2012**
(21) Application number: 11250593.8
(22) Date of filing: 16.06.2011
(51) Int. Cl.: G01R 13/02

(54) **Qualified edge triggering in a test and measurement instrument**

(30) Priority: 30.06.2010 US 828160
(71) Applicant: Tektronix, Inc., Beaverton, Oregon 97077-0001 (US)
(72) Inventor: Sullivan, Steven K., Beaverton, Oregon 97006 (US); Beale, Terrance R., Portland, Oregon 97229 (US); Veith, Kristie L., Portland, Oregon 97229 (US)
(74) Representative: Brinck, David John Borchardt

(57) **Abstract**

A digital storage oscilloscope employs an improved edge triggering circuit that discards some of trigger events when it determines that there are many more trigger events than the oscilloscope can use. The determination is made in response to detection of a characteristic of the signal that indicates a repetitive nature of a complex signal. Certain trigger events are selected to be acted upon, and others are discarded, in response to the determination. The circuitry dynamically reacts to changes in the input signal in response to detection of different criteria for a characteristic of repetition as the input signal changes.

## Description

### Field of the Invention

The subject invention, in general, concerns the field of test and measurement instruments, such as digital storage oscilloscopes, or logic analyzers, or the like, and specifically concerns apparatus for triggering a test and measurement instrument.

### Background of the Invention

A modem test and measurement instrument, such as a DPO4024 digital storage oscilloscope, manufactured by Tektronix, Inc., Beaverton, Oregon, acquires a signal under test (SUT) from a device under test (DUT), and stores a portion of interest of the SUT in a memory in response to detection of a trigger event in the SUT.

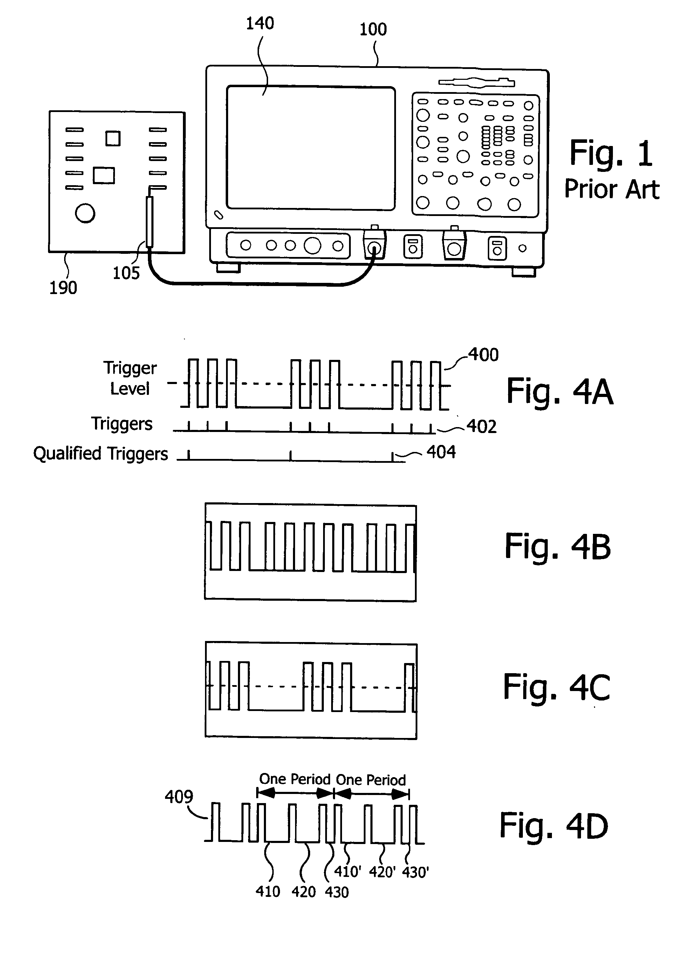

FIGURE 1 is an illustration showing a digital storage oscilloscope **100,** as known from the prior art, having a probe **105** in contact with a device under test (DUT) **190** for acquiring, processing, and performing measurements on a signal under test (SUT) that is present at the contact point on DUT **190.** The processed acquired signals are ultimately displayed on display device **140.**

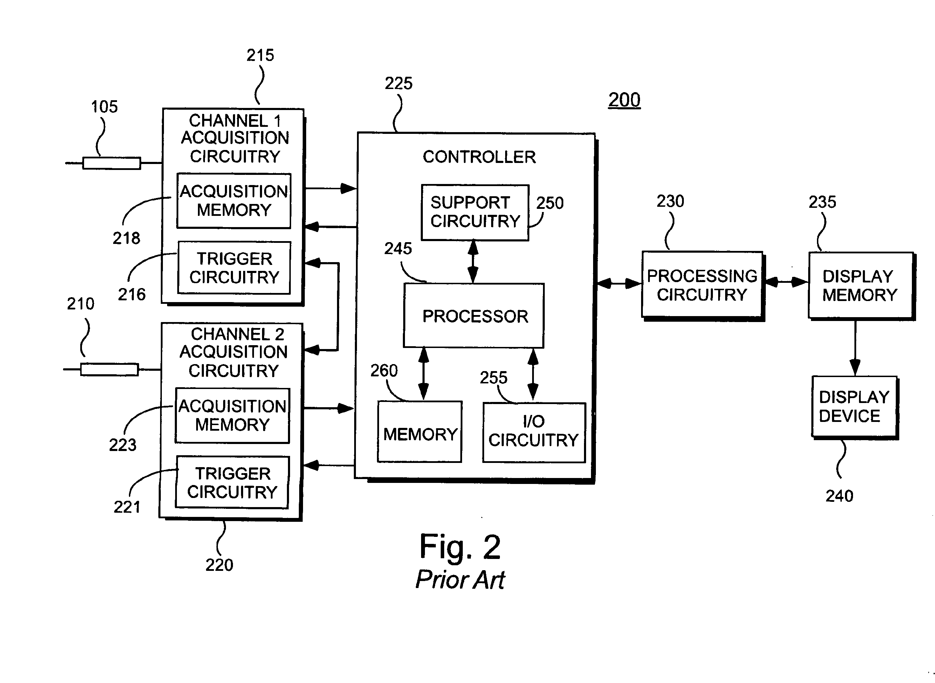

FIGURE 2 depicts a simplified high level block diagram **200** of the operational portions of prior art oscilloscope **100.** In particular, oscilloscope **100** utilizes a first probe **105** and may use a second probe **210,** and includes Channel 1 Acquisition circuitry **215,** Channel 2 Acquisition circuitry **220,** a Controller **225,** processing circuitry **230,** a display memory **235,** and a display device **240.** Probes **105** and **210** may be any conventional voltage or current probes suitable for detecting analog voltage or current signals from DUT **190,** respectively.

Probes **105** and **210** may be, for example, active probe model numbers P2202, TCP202, manufactured by Tektronix, Inc., and may be used to acquire real time signal information from DUT **190.** The output signals of probes **105** and **210** are sent to the Channel 1 Acquisition circuitry **215** and Channel 2 Acquisition circuitry **220,** respectively. Although only two probes and two oscilloscope channels are shown for simplicity, one skilled in the art will recognize that any reasonable number of probes and channels, such as four, may be employed.

Channel 1 Acquisition circuitry **215** and Channel 2 Acquisition circuitry **220** each include, illustratively, analog-to-digital conversion circuitry (not shown), triggering circuitry **216, 221,** decimator circuitry (not shown), acquisition memory **218, 223,** and the like. Acquisition circuitry **215** and **220** operate to digitize, at a sample rate, "S", one or more of the signals under test to produce one or more respective acquired sample streams suitable for use by Controller **225** or Processing circuitry **230.** Acquisition circuitry **215** and **220,** in response to commands received from Controller **225,** change trigger conditions, decimator functions, and other acquisition-related parameters. Each of Acquisition circuitry **215, 220** communicates its respective resulting sample stream to Controller **225.** Each of Acquisition circuitry **215, 220** communicates with each other to coordinate trigger criteria and acquisition location in time.

Controller **225** operates to process the one or more acquired sample streams provided by the Acquisition circuitry **215** and **220** to generate respective waveform data associated with one or more sample streams. That is, given desired time per division and volts per division display parameters, Controller **225** operates to modify or rasterize the raw data associated with an acquired sample stream to produce corresponding waveform data having the desired time per division and volts per division parameters. Controller **225** may also normalize waveform data having non-desired time per division, volts per division, and current per division parameters to produce waveform data having the desired parameters. Controller **225** provides the waveform data to processing circuitry **230** which, in turn, stores the waveform data in Display Memory **235** for subsequent presentation on display device **240.**

Processing circuitry **230** comprises data processing circuitry suitable for converting acquired sample streams or waveform data into image or video signals, which are adapted to provide visual imagery (e.g., display formatting and driver circuitry, and the like). Processing circuitry **230** may include Display Memory **235** and Display Device **240** (e.g., a built-in display device) or provide output signals (e.g., via a video driver circuit) suitable for use by an external display device **240.**

Controller **225** of FIGURE 2 preferably includes a Processor **245,** support circuits **250,** I/O circuitry **255** and Memory **260.** Processor **245** cooperates with conventional support circuitry **250,** such as power supplies, clock circuits, cache memory, and the like, as well as circuits that assist in executing software routines stored in Memory **260.** As such, it is contemplated that some of the process steps discussed herein as software processes may be implemented within hardware, for example, as circuitry that cooperates with Processor **245** to perform various steps. Controller **225** also contains input/output (I/O) circuitry **255** that forms an interface between the various function elements communicating with Controller 225. For example, devices (not shown) intended to be coupled to I/O circuitry **255** may comprise a keypad, pointing device, touch screen, or other means adapted to provide user input to, and output from, Controller **225.** Controller **225,** in response to such user input, illustratively adapts the operations of Acquisition circuitry **215** and **220** to perform various data Acquisitions, triggering, processing, display communications, among other functions. In addition, the user input may be used to trigger automatic calibration functions, or adapt operating parameters of display device **240,** logical analysis, or other data acquisition devices.

Acquisition Memories in Acquisition Circuitry **215, 220,** Processor Memory **260,** and Display Memory **235,** are shown as separate memories for ease of explanation, but may be included within the same physical memory. In addition, these memories may include volatile memory, such as SRAM, DRAM, among other volatile memories, and may also include non-volatile Memory devices, such as a disk drive or a tape medium, among others, or programmable memory, such as an EPROM, among others.

The most commonly used trigger mode in digital storage oscilloscopes is edge triggering. Triggering Circuitry **216, 221** of Acquisition Circuitry **215, 220,** performs conventional edge triggering well for simple repetitive signals, such as a sine wave or a train of clock pulses. However, conventional edge triggering fails to provide a stable display when attempting to trigger on even slightly more complex signals. For example, refer to FIGURES 4a and 4b and consider a signal **400** that consists of repetitions of three pulses. The oscilloscope may trigger on the first pulse of the repeating trio at one time (as shown in FIGURE 4c), but may trigger on a different pulse at another time, producing the display shown in FIGURE 4b.

Most oscilloscopes contain a trigger holdoff circuit which can often be used to make a stable display. However, digital oscilloscope users rarely use this feature, partly because this feature is difficult to use properly.

U.S. Patent No. 4,771,193, issued to Genichiro Ohta on September 13, 1988 shows an analog circuit for triggering on a maximum length pulse within an input signal. As shown in FIGURE. 2 of the '193 patent, an input digital signal (a) produces a ramp signal (b) for each pulse, the height of the ramp being a function of the width of the pulse. A capacitor is charged, as shown by signal (c), and enables a sweep (I) that starts at the conclusion of the longest pulse. In this way, the measuring instrument triggers on a non-signal interval indicated by the longest pulse width. This trigger circuit operates on a peak detection basis, (i.e., triggering on the highest peak of the ramp signal (b)).

U.S. Patent No. 5,223,784, issued to Diller, et al. on June 29, 1993, shows a circuit for triggering an acquisition system only once during a period of an input signal. A first trigger comparator detects qualifying trigger events in an input signal using a first reference trigger level, which qualifying trigger events charge a capacitor. A second trigger comparator compares the voltage on the capacitor with a second reference trigger level, and produces a pulse if the capacitor voltage has a predetermined relationship to the second reference trigger level. Subsequent trigger events which occur before a predetermined period of time, determined by an RC time constant, are unable to produce another trigger event. Specifically, Diller '784 discloses circuits that will recognize a pattern. It should be noted that the circuits of 5,223,784 are not adaptive.

The above-discussed patents are analog trigger circuit implementations. With the current digital storage oscilloscopes digital trigger circuit implementations are generally desired.

U.S. Patent No. 7,072,804, issued to Dennis J. Weller on July 4, 2006, discloses a digital trigger circuit having an input filter for producing low and high frequency rejection trigger signals, as well as AC and DC trigger signals, derived from a digitized input signal. One of the four trigger signals is selected by a multiplexer and input to a trigger comparator having an upper trigger level and a lower trigger level to provide a desired amount of hysteresis, one trigger level being a desired trigger level and the other being a hysteresis level.

U.S. Patent Application Serial No. 11/781,202, Self Adjusting Holdoff Trigger (Sullivan et al.), published as Publication No. 2008/0030239, and assigned to the same assignee as the subject application, concerns circuitry to avoid triggering on "false" edge triggers caused by not enough hysteresis (or no hysteresis).

US Patent 6,621,913, Digital Oscilloscope with Trigger Qualification Based on Pattern Recognition, (Johan deVries), issued 16 September 2003, and assigned to Fluke Corporation, discusses trigger circuits to make a stable display. Specifically, deVries '913 concerns hold-off circuitry to make a stable display by blocking some triggers.

Unfortunately, none of the prior art references discussed above provides a stable display on an oscilloscope, when the oscilloscope is performing edge triggering on a complex waveform.

### Summary of the Invention

A digital storage oscilloscope employs an improved edge triggering circuit that discards some of trigger events when it determines that there are many more trigger events than the oscilloscope can use. The determination is made in response to detection of a characteristic of the signal that indicates a repetitive nature of a complex signal. Certain trigger events are selected to be acted upon, and others are discarded, in response to the determination. Circuitry according to the subject invention dynamically reacts to changes in the input signal in response to detection of different criteria for a characteristic of repetition as the input signal changes.

### Brief Description of the Drawing

FIGURE 1 is an illustration showing a digital storage oscilloscope 100, as known from the prior art.

FIGURE 2 depicts a simplified high level block diagram of the operational portions of the prior art oscilloscope of FIGURE 1.

FIGURE 3 depicts a simplified high level block diagram of the operational portions of an oscilloscope according to the subject invention.

FIGURES 4A, 4B, 4C, and 4D show waveforms for use in understanding the subject invention.

FIGURE 5 shows Trigger Qualification Circuitry in accordance with an embodiment of the subject invention.

FIGURE 6 shows Trigger Qualification Circuitry in accordance with a second embodiment of the subject invention.

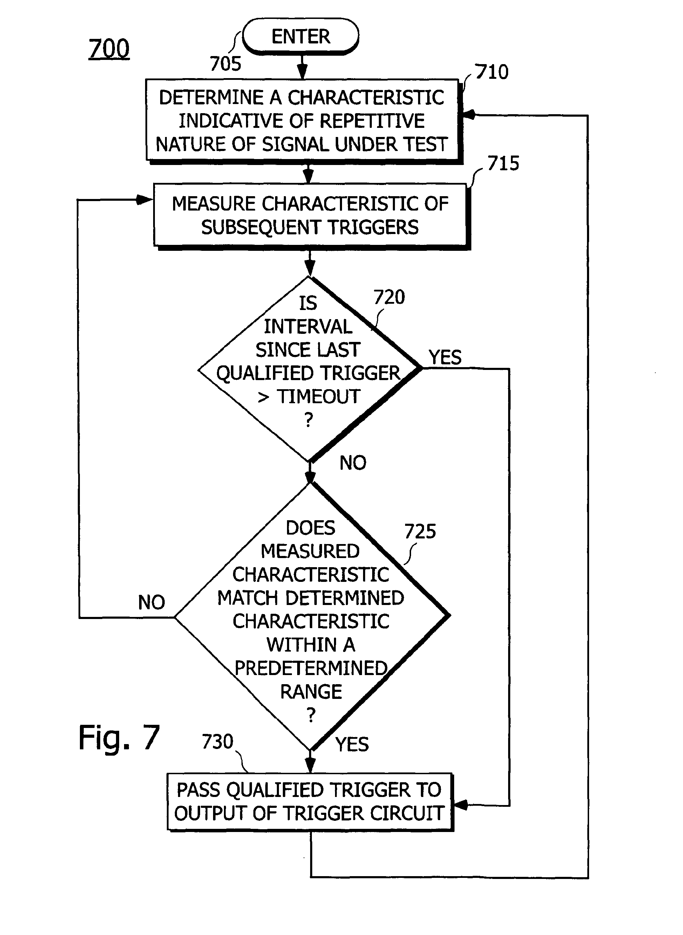

FIGURES 7, 8, 9, and 10 are flowcharts illustrating embodiments of the method of the subject invention.

### Detailed Description of the Invention

It is herein recognized that Edge Trigger circuitry can be modified such that it tends to trigger on the first pulse of a sequence of pulses. The result is the display shown above in FIGURE 4C. The oscilloscope is still triggering on an edge but the subject improved edge trigger tends to make a stable display when the signal is more complex than a sine wave or clock signal. Such an improved edge trigger saves oscilloscope users time and makes their job much easier.

For simple signals like a sine wave or a logic level clock, circuitry according to the subject invention works just like ordinary edge trigger in an oscilloscope. However, when there are many more trigger events than the oscilloscope can use, then circuitry according to the subject invention will discard some of those trigger events. It looks for a characteristic of the signal that may indicate a repetitive nature of the signal. That is, a more complex characteristic than would be found in a sine wave or a logic level clock. It will use this characteristic to select trigger events that are to be passed on and those that are to be discarded. The circuit dynamically reacts to changes in the input signal finding different criteria for a characteristic of repetition as the input signal changes.

The subject invention detects repetitive patterns in signals and then uses this information to discard most of the edge triggers; using any of the remaining edge triggers will result in a stable display. The subject invention uses a number of heuristic (i.e., trial and error) techniques which are suitable for use with a limited number of kinds of repetitive waveforms, respectively.

Heuristic #1 ― Find widest gap in the triggers

First, we define a time interval that will be used when looking for a repetitive pattern in the trigger signal. For purposes of the following explanation, assume that this interval is the average time between one waveform that is displayed, and the next waveform that is displayed.

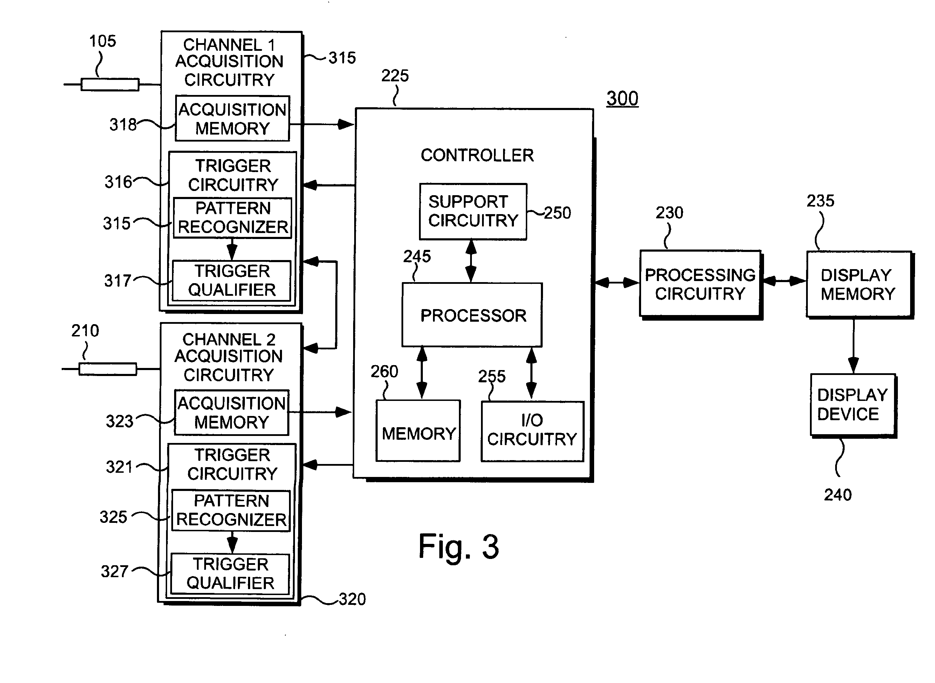

Referring to FIGURES 3 and 4, a pattern recognizer circuit 315, 325 detects a particular pattern (i.e. waveshape) in an acquired waveform 400 , such as, a rising edge, a falling edge, a "runt" (i.e., smaller than normal) signal, wide pulse width, narrow pulse width, and so on. Any suitable pattern recognizer (either analog or digital) may be used as pattern recognizer 315, 325. One such pattern recognizer (or event decoder) is known from U.S. Patent 7,191,079 (Patrick A. Smith, et al.), issued 13 March 2007 and assigned to the same assignee as the subject application. Upon detecting a desired trigger pattern in waveform **400,** Pattern Recognizer **315, 325** passes an unqualified trigger signal **402** to a Trigger Qualifier Circuit **317, 327.** Trigger Qualifier Circuit **317, 327** then analyzes the unqualified trigger signal and finds a characteristic of the trigger signal that is likely to be repeating at the same rate as the repetition rate of the signal.

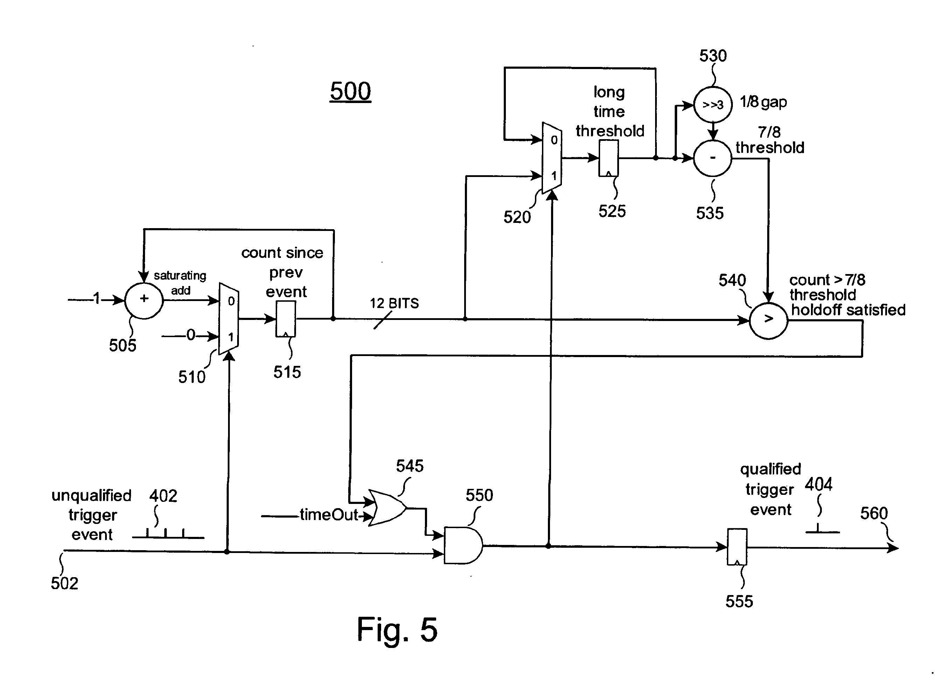

Referring also to FIGURE 5, in the above example of three pulses of waveform **400** of FIGURE 4A, circuitry **500** may measure the longest time between trigger events. Note that in every repetition of the three pulses of waveform **400** there is one long period of time between the three pulses. Trigger Qualifier Circuit **317, 327.will** detect this long period, which is a characteristic that happens only once in each repetition.

A first embodiment of Trigger Qualifier Circuit **317,** 327 is shown in FIGURE 5 as circuitry **500** for detecting trigger events which exceed a Long Time Threshold value indicative of a long time period. An Unqualified Trigger Event waveform representing a series of edge trigger events **402** is received at an input terminal **502** and applied to the control terminal of a multiplexer switch **510,** and to one input of an AND-gate **550.** At this time, the second input of AND-gate **550** has been pulled to a logic low level, forcing AND-gate **550** to maintain a 0 (logic low level) output. A 12-bit Latch **515** is clocked with a periodic clock signal (preferably the acquisition clock signal) to latch a respective array of bits presented to its input. The array of 12 bits is indicative of a number of counts of the periodic clock signal. So long as waveform **402** remains in its logic low level state, then the count will increment, starting from 0000 0000 0000 and saturating at a count of 1111 1111 1111, without wrapping around. That is, each count is incremented in a Saturating Adder **505** by applying the current count to one input of Saturating Adder **505** and applying a fixed count of 0000 0000 0001 to the other input of the Saturating Adder. Each incremented count is applied to latch **515** via input switch terminals 0 of Multiplexer Switch **510.** While the maximum bit count has been described as 12, any reasonable number of bits can be used.

Each trigger event that is applied to the control input of Multiplexer Switch **510,** causes a reset of the count by switching the input terminals of Multiplexer Switch **510** from input 0 to input 1. That is, input 1 of Multiplexer Switch **510** is hardwired to a count of 0000 0000 0000, causing a count of 0000 0000 0000 to be latched by 12-bit Latch **515** upon the next occurrence of the periodic clock signal following receipt of an unqualified trigger event.

The latched 12-bit count is applied to a second Multiplexer Switch **520,** and to a digital comparator **540.** Normally, signals at the 0 input of Multiplexer Switch **520** are conveyed to the input of a Long Time Threshold Latch **525.** The output of Long Time Threshold Latch **525** is coupled around to input terminals 0 of Multiplexer Switch **520** to ensure that the longest time between Trigger Events is retained. The 12-bit output of Multiplexer Switch **525** is also applied to the minuend input of a subtractor circuit **535,** and to the input of a divider circuit **530.** Circuits **530** and **535** provide a tolerance of +0, - 1/8 of the current count. The text label, "»3", on Divider **530** is meant to convey the notion that the Long Time Threshold count value presented at its input is right-shifted by three positions (i.e., a divide by 8). The divided count is then applied to the subtrahend input of subtractor **535.** The result is that 1/8 of the Long Time Threshold count is subtracted from the Long Time Threshold count, creating a new threshold value of 7/8 of the Long Time Threshold count.

The new threshold value of 7/8 of the Long Time Threshold count is compared to the current count (i.e., the count since the previous trigger event) in Digital Comparator **540.** If the current count exceeds 7/8 of the Long Time Threshold count, then the Threshold Holdoff Period has been exceeded, and the next trigger event will be accepted. That is, digital comparator **540** produces a logic high level signal when the threshold Holdoff value has been exceeded, and that logic high level signal is applied to one input of an OR-gate **545.** The application of that high level signal causes OR-gate **545** to apply a high level signal to one input of AND-gate **550.** This action predisposes AND-gate **550** to pass the next high level signal it receives on its other input terminal, to a third latch **555.** Latch **555** is also preferably clocked with the Acquisition clock signal to latch the data at its input, and convey it to an output terminal **560,** as a Qualified Trigger Event **404.**

When the accepted trigger event appears at the output of AND-gate **550,** it is also coupled to the control input of Multiplexer switch **520.** This causes Multiplexer switch **520** to pass the current count to the input of Latch **525** to be the new Long Term Threshold count. In the event that an inordinately long time passes between qualified trigger events, a timer (not shown) counts a predetermined time period since the last Qualified Trigger Event and then produces a "time out" pulse to force the acceptance of the next trigger event and resetting the count of Latch **515** and Latch **525** to 0000 0000 0000.

Summarizing, Trigger Qualifier Circuit **317, 327** discards (or blocks) some edge trigger events leaving only one trigger event for each repetition of the trigger signal. In the above example, Pattern Recognizer Circuit **315, 325** will pass to Trigger Qualifier Circuit **317, 327,** an Unqualified Trigger Event Signal **402** exhibiting the longest time found between trigger events, in this case, a series of edge triggers. Trigger Qualifier Circuit **317, 327** measures the actual time between subsequent trigger events. When the time between trigger events is less than 7/8ths of the longest time between edges in the repetitive signal, the edge trigger event is not used. Only when the time between trigger events is longer than 7/8ths of the longest time between edges will the edge trigger event pass through the circuit and become a trigger that may be used to trigger the oscilloscope.

Referring to FIGURE 4A again, note that Qualified Trigger Event **404** occurs at the start of each triplet of waveform **400.** This is exactly what is needed to trigger the oscilloscope to produce the stable display of FIGURE 4C.

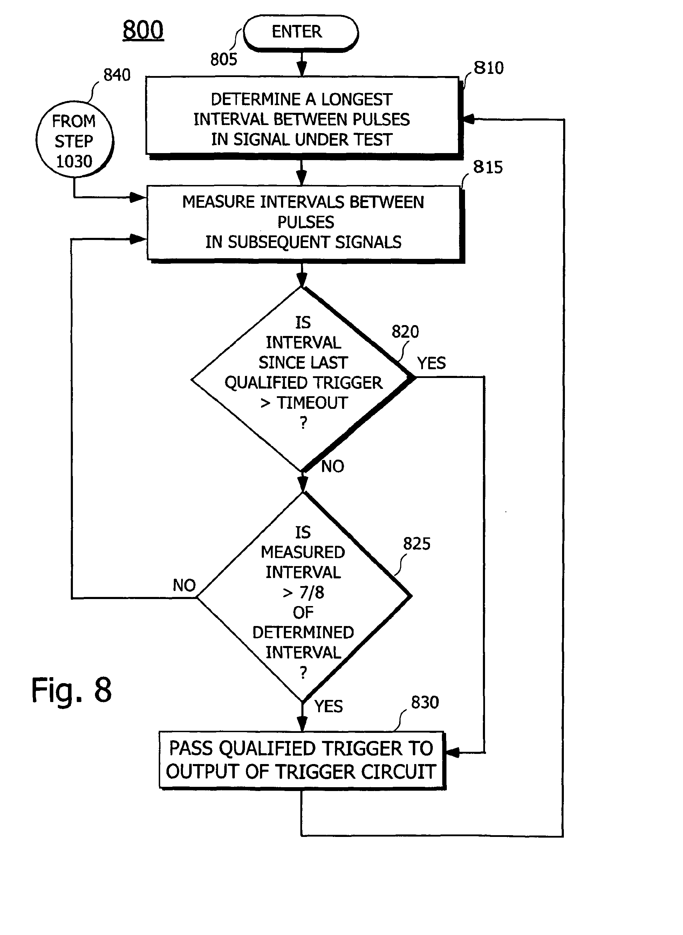

The above described operation according to Heuristic #1 is shown in the flowchart **800** of FIGURE 8. The routine is entered at step **805** and progresses to step **810** in which a determination is made of a longest interval between pulses in a signal under test. Subsequent long intervals in the signal under test are compared to this Longest Threshold value in step **815.** In step **820,** a determination is made if the current longest interval exceeds the "time out" period. If so, the routine advances along the YES path to step **830** and "forces" acceptance of a Qualified trigger. The program then loops around to step **810** in continuous operation.

If, at step **820,** it were found that the current longest interval does not exceed the "time out" period, then the NO path is taken to step **825** in which a determination is made if the current measured interval is greater then 7/8 of the Longest Threshold value. If so, then the YES path is taken to step **830** wherein a Qualified trigger is accepted. The program then loops around to step **810** in continuous operation. On the other hand, if at step **825,** it were found that the current measured interval is less than, or equal to, 7/8 of the Longest Threshold value, then the NO path is taken to loop around to step **815,** and no Qualified Trigger is accepted.

Heuristic #2 ― Find narrowest gap in the triggers

The first heuristic works well on signals such as the three pulses shown in the waveform of FIGURE 4A. It does not work well when the signal consists of pulses that are equally spaced except for an occasional pair of pulses that are closer. Such a signal is shown in FIGURE 4D. Referring to FIGURE 4D, a waveform **409** includes a series of pulses separated by low logic level portions **410, 420, 430, 410', 420'** and **430'.** Note that low logic level portions **410, 420, 410',** and **420'** all exhibit a period having the same first duration. Note also that low logic level portions **430** and **430'** are of a shorter, second duration.

A trait (i.e., characteristic) of waveform **409** that allows the period to be discovered is the short time duration of low logic level portions **430** and **430'** occurring between two rising edges. Circuitry that would produce a stable display would be similar to that used by Heuristic #1 (i.e., FIGURE 5), except that the Pattern Recognizer Circuit **315, 325** would find the minimum time between trigger events, rather than the maximum time between trigger events, and would employ a Trigger Qualifier Circuit **600** that would discard all triggers with a trigger-to-trigger time period that is 1.25 times longer than the minimum time found by the pattern recognizer circuit.

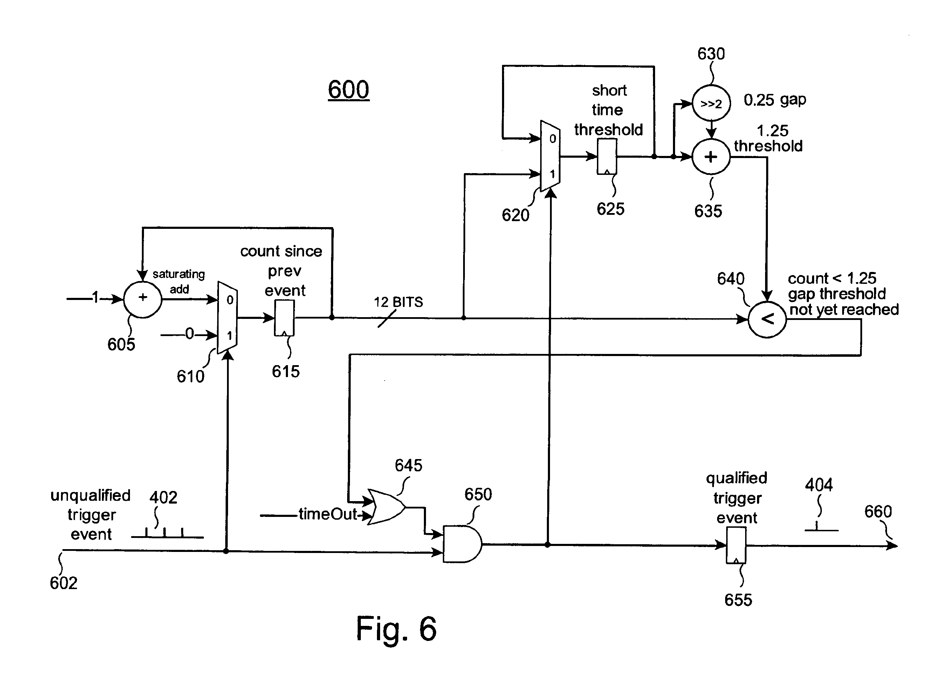

Such a Trigger Qualifier Circuit **600** is shown in FIGURE 6. A waveform representing a series of unqualified edge trigger events **402** is received at an input terminal **602** and applied to the control terminal of a multiplexer switch **610,** and to one input of an AND-gate **650.** At this time, the second input of AND-gate **650** has been pulled to a logic low level, forcing AND-gate **650** to maintain a 0 (logic low level) output. A 12-bit Latch 615 is clocked with a periodic clock signal (preferably the acquisition clock signal) to latch a respective array of bits presented to its input. The array of 12 bits is indicative of a number of counts of the periodic clock signal. So long as waveform **402** remains in its logic low level state, then the count will increment, starting from 0000 0000 0000 and saturating at a count of 1111 1111 1111, without wrapping around. That is, each count is incremented in a Saturating Adder **605** by applying the current count to one input of Saturating Adder **605** and applying a fixed count of 0000 0000 0001 to the other input of the Saturating Adder. Each incremented count is applied to latch **615** via input switch terminals 0 of Multiplexer Switch **610.** While the maximum bit count has been described as 12, any reasonable number of bits can be used.

Each trigger event that is applied to the control input of Multiplexer Switch **610,** causes a reset of the count by switching the input terminals of Multiplexer Switch **610** from input 0 to input 1. That is, input 1 is hardwired to a count of 0000 0000 0000, causing a count of 0000 0000 0000 to be latched by 12-bit Latch **615** upon the next occurrence of the periodic clock signal following receipt of an unqualified trigger event.

The latched 12-bit count is applied to a second Multiplexer Switch **620,** and to a digital comparator **640.** Normally, signals at the 0 input of Multiplexer Switch **620** are conveyed to the input of a Short Time Threshold Latch **625.** The output of Short Time Threshold Latch **625** is coupled around to input terminals 0 of Multiplexer Switch **620** to ensure that the shortest time between Trigger Events is retained. The 12-bit output of Multiplexer Switch **625** is also applied to an input of an adder circuit **635,** and to the input of a divider circuit **630.** Circuits **630** and **635** provide a tolerance of + 1/4 (i.e., +0.25) of the current count. The text label, "»2", on Divider **630** is meant to convey the notion that the Short Time Threshold count value presented at its input is right-shifted by two positions (i.e., a divide by 4). The divided count is then applied to the other input of adder **635.** The result is that 1/4 of the Long Time Threshold count is added to the Short Time Threshold count, creating a new threshold value of 1.25 times the Short Time Threshold count.

The new threshold value of 1.25 times the Short Time Threshold count is compared to the current count (i.e., the count since the pervious trigger event) in Digital Comparator **540.** If the current count is less than 1.25 of the Long Time Threshold count, then the Threshold Holdoff Period has not been exceeded, and the next trigger event will be accepted. That is, digital comparator **640** produces a logic high level signal when the threshold Holdoff value has not been exceeded, and that logic high level signal is applied to one input of an OR-gate **645.** This action causes OR-gate **645** to apply a high level signal to one input of AND-gate **650,** which predisposes AND-gate **650** to pass the next high level signal it receives on its other input terminal, to a third latch **655.** Latch **655** is also preferably clocked with the Acquisition clock signal to latch the data at its input, and convey it to an output terminal **660**, as a Qualified Trigger Event **404.**

When the accepted trigger event appears at the output of AND-gate **650,** it is also coupled to the control input of Multiplexer switch **620.** This causes Multiplexer switch **620** to pass the current count to the input of Latch **625** to be the new Short Term Threshold count. In the event that an inordinately long time passes between qualified trigger events, a timer (not shown) counts a predetermined time period since the last Qualified Trigger Event and then produces a "time out" pulse to force the acceptance of the next trigger event and resetting the count of Latch **615** and Latch **625** to 0000 0000 0000.

Summarizing, Trigger Qualifier Circuit **317, 327** discards (or blocks) some edge trigger events leaving only one trigger event for each repetition of the trigger signal. In the above example, Pattern Recognizer Circuit **315, 325** will pass to Trigger Qualifier Circuit **317, 327,** an Unqualified Trigger Signal **402** exhibiting the longest time found between trigger events, in this case a series of edge triggers. Trigger Qualifier Circuit **317, 327** measures the actual time between subsequent trigger events. When the time between trigger events is greater than 1.25 times the time found by Pattern Recognizer **315, 325,** the edge trigger event is not used. Only when the time between trigger events is shorter than 1.25 times the pattern recognizer time will the edge trigger event pass through the circuit and become a trigger that may be used to trigger the oscilloscope.

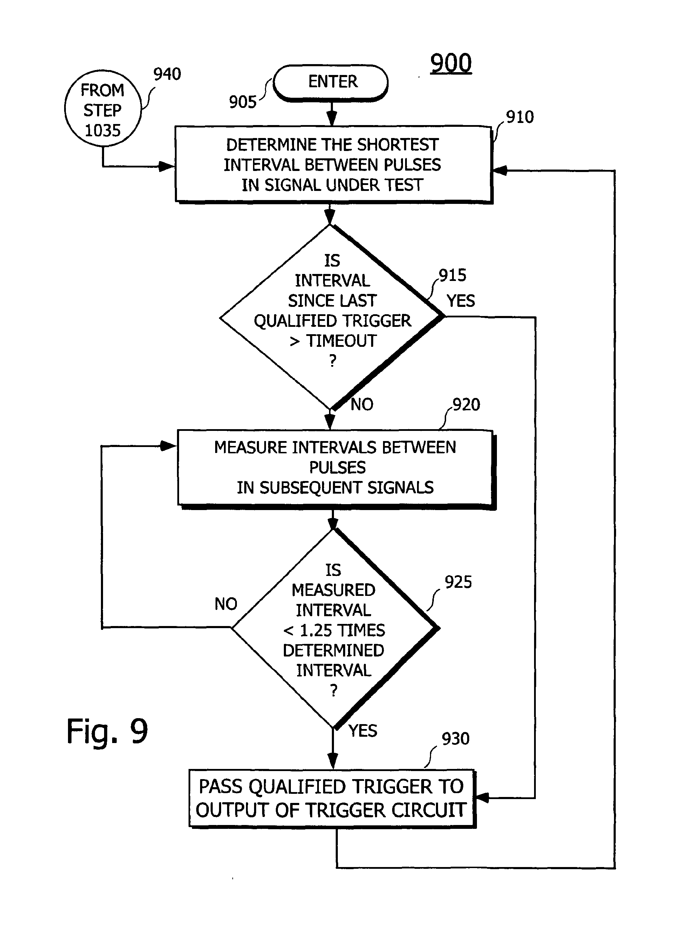

The above described operation according to Heuristic #2 is shown in the flowchart **900** of FIGURE 9. The routine is entered at step **905** and progresses to step **910** in which a determination is made of a shortest interval between pulses in a signal under test. Subsequent short intervals in the signal under test are compared to this Shortest Threshold value in step **925.** In step **915,** a determination is made if the current shortest interval exceeds the "time out" period. If so, the routine advances along the YES path to step **930** and "forces" acceptance of a Qualified trigger. The program then loops around to step **910** in continuous operation.

If, at step **915,** it were found that the current shortest interval does not exceed the "time out" period, then the NO path is taken to step **920** at which the intervals between pulses of subsequent signals are measured. At step **925** a determination is made if the current measured interval is less than 1.25 times the Shortest Threshold value. If so, then the YES path is taken to step **930** wherein a Qualified trigger is accepted. The program then loops around to step **910** in continuous operation. On the other hand, if at step **925,** it were found that the current measured interval is greater than, or equal to, 1.25 times the Shortest Threshold value, then the NO path is taken to loop around to step **920,** and no Qualified Trigger is accepted.

Heuristic #3 - Finding both widest and narrowest gaps

Since the repetition of some signals is characterized by a long period between triggers while other signals it is a short time between triggers, Heuristic #3 measures both the longest gap and the shortest gap. In addition, the average time between trigger events is also measured. Since circuitry for finding the longest gap and circuitry for finding the shortest gap have already been described with respect to FIGURES 5 and 6, one skilled in the art would readily see how to combine them, and this combined circuitry need not be described in detail.

Such a combined trigger qualifier circuit uses these three values, longest gap, shortest gap, and average time between trigger events. It compares the minimum and maximum trigger gap to the average trigger rate. The one that is furthest from the average determines which of the first two heuristics is used. If the maximum gap is furthest from the average trigger rate, the signal is assumed to be a group of pulses and heuristic #1 is used to exclude triggers. If the minimum gap is the furthest from the average trigger rate, the signal is assumed to have a distinguishing narrow gap and heuristic #2 is used to exclude triggers.

For the first example of three pulses as shown in FIGURE 4A, the minimum trigger gap (i.e., low logic level portion) is 2 units, the average trigger rate is 3.67 units and the maximum trigger gap is 7 units. The maximum gap is 2.33 units away from the average, while the minimum gap is only 1.67 units away from the average. Therefore Heuristic #1 is chosen for use because that choice will result in a stable display:

For the second signal, with two pulses close together, as shown in FIGURE 4D, the minimum trigger gap is 2 units, the average trigger rate is 3.33 units and the maximum trigger gap is 4 units. The minimum gap is 1.33 units away from the average while the maximum gap is only 0.67 units away from the average. Therefore Heuristic #2 is chosen for use because that choice will result in a stable display.

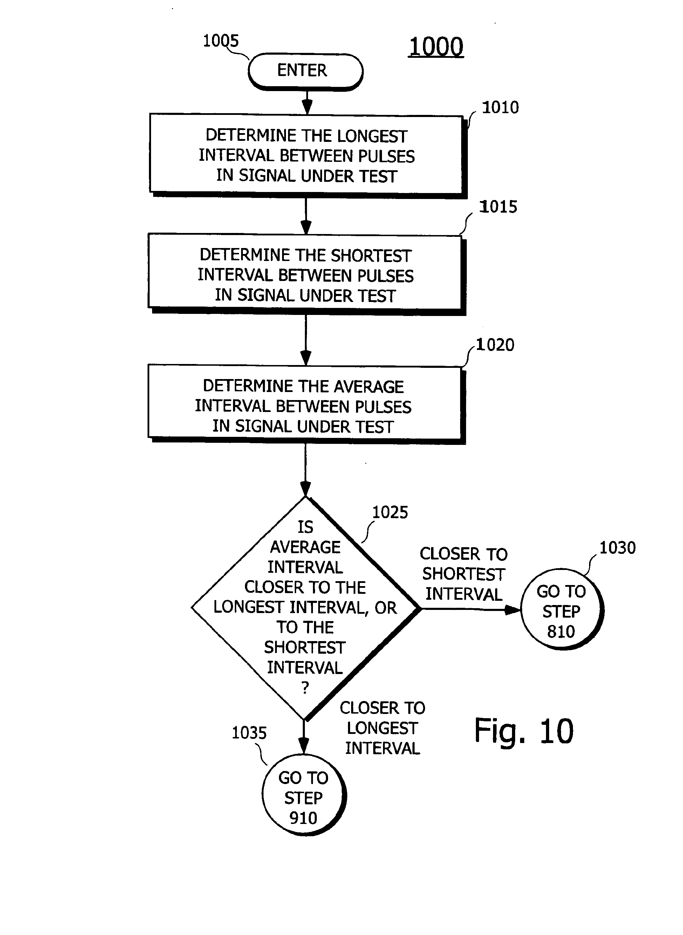

The above described operation according to Heuristic #1 and Heuristic #2 is shown in the flowchart **1000** of FIGURE 10. The routine is entered at step **1005** and progresses to step **1010** in which a determination is made of a longest interval between pulses in a signal under test. The routine then progresses to step **1015** in which a determination is made of a shortest interval between pulses in a signal under test. In step **1020,** a determination is made of the average time interval between pulses. In step **1025** a determination is made as to whether the average interval is closer to the Longest interval or to the Shortest interval. If closer to the shortest interval, then the routine is exited at step **1030** and enters the routine of FIGURE 8 at step **840.** On the other hand, if the average interval is closer to the longest interval, then the routine is exited at step 1035 and entered the routine of FIGURE 9 at step 940.

Heuristic #4 ― Continuous operation

The subject invention is capable of operating in a batch mode implementation wherein the pattern recognizer circuit works over a period of time, making an assessment at the end of this period of time that is then passed to the trigger qualifier circuit. An alternative mode of operation is to have the pattern recognizer continuously updating and the trigger qualifier continuously using this updated value.

For example, to find the approximate size of the longest gap between triggers the trigger qualifier can measure each gap, compare it with a maximum and update the maximum when the measured value is larger. The trigger qualifier circuit can pass all trigger events that are longer than 7/8ths of the maximum gap length.

A mechanism is required to reduce the maximum should the trigger source change to a faster trigger rate. One way this can be done is to measure the time since the last qualified trigger. If this time becomes longer than a predetermined period of time, perhaps related to the maximum drawing rate, then the maximum gap length can be set to zero.

An alternative mechanism to reduce the maximum is to have the maximum reduced by a small amount on every clock cycle in which the maximum is not set to a new maximum value. The reduction can be accomplished by subtracting a small fraction of the current maximum value. For example, the maximum can be reduced by 1/256 of its value by subtracting a right-shifted value from itself. One skilled in the art will recognize that fractional bits are needed in order to keep round-off errors from preventing proper operation.

The actual amount of the reduction is chosen so that the maximum will decrease to a value that is small enough to pass trigger events at the fastest rate within a time that is acceptable to the oscilloscope operator. For example, if the trigger rate changes from 100Hz to the maximum trigger rate without some way of reducing the maximum value, the circuit will never allow a qualified trigger to be generated. If the maximum value is being continuously reduced, it must be reduced quickly enough to a small enough value that will allow the maximum trigger rate to become qualified within a time similar to the auto-holdoff time. It should also be clear that the maximum value will itself be limited in range so that it never can become particularly large, even when there are no trigger events for a long period of time.

In general, in these examples, the input to the pattern recognizer circuit has been the "raw" edge trigger events. This invention also works well with other kinds of information. For example, both rising and falling edge trigger events could be applied to the pattern recognize circuitry. A further characteristic of a signal repetition might be a time between a falling edge and the next rising edge. In yet another embodiment, the digitized signal is applied to the pattern recognizer and any measurable characteristic of the signal, such as spectral content, could be used to identify a unique aspect of each repetition of the signal.

Although the pattern recognizer circuit and the trigger qualifier circuit work quite well over a predetermined period of time that is about as long as the time that elapses between the drawing of each waveform, other periods of time are also suitable. If a longer period of time is used, the circuit may take longer to adapt to a change in the signal. When a change in the signal happens, perhaps because the user is probing different signals, the timeout allocated to the trigger qualifier can be set to be on a time scale similar to human movement and reaction time. If a shorter period of time is used, the pattern recognizer may not view a full repetition.

Although Controller **225** of FIGURE 2 is depicted as a general purpose microcomputer that is programmed to perform various control functions in accordance with the present invention, the invention may be implemented in hardware such as, for example, an application specific integrated circuit (ASIC). As such, it is intended that Processor **225,** as described herein, be broadly interpreted as being equivalently performed by hardware, software, or by a combination thereof.

It will be appreciated by those skilled in the art that standard signal processing components (not shown), such as signal buffering circuitry, signal conditioning circuitry, and the like are also employed as required to enable the various functions described herein.

The term "OR" as used in the following claims is used in the inclusive sense (i.e., one, or the other, or both). Moreover, use of the conjunction "OR" is not intended to limit the claims to embodiments in which both alternatives must be present; one is sufficient.

## Claims

1. A digital triggering arrangement for a test and measurement instrument, comprising:
a pattern recognizer, said pattern recognizer receiving data indicative of a selection of a predetermined event, said predetermined event being a rising edge, a falling edge, a runt, a pulse width having a duration longer than a predetermined time, or a pulse width having a duration shorter than a predetermined time, and receiving a signal under test, and producing an output signal indicative of the occurrence of all of said selected predetermined events in said received signal under test;
qualifying circuitry, said qualifying circuitry measuring a first characteristic of said output signal, said first characteristic being indicative of repetition of said received signal under test;
comparing circuitry coupled to said qualifying circuitry, said comparing circuitry comparing said first characteristic against a second characteristic, said second characteristic being a subsequent occurrence of said first characteristic; and
qualified trigger signal generation circuitry coupled to said comparing circuitry, said trigger generating circuitry generating a qualified trigger signal when said comparing circuitry determines that that said second characteristic is within a predetermined tolerance of said first characteristic, and inhibiting generation of said qualified trigger signal when said comparing circuitry determines that said second characteristic is not within a predetermined tolerance of said first characteristic.

2. The digital triggering arrangement of claim 1, wherein:
said first characteristic is the longest period between recurrences of a predetermined event.

3. The digital triggering arrangement of claim 2, wherein:
said first characteristic is continually updated to dynamically react to changes in said received signal in response to detection of different criteria for a characteristic of repetition as said received signal changes.

4. The digital triggering arrangement of claim 1, wherein:
said first characteristic is the shortest period between recurrences of a predetermined event.

5. The digital triggering arrangement of claim 4, wherein:
said first characteristic is continually updated to dynamically react to changes in said received signal in response to detection of different criteria for a characteristic of repetition as said received signal changes.

6. The digital triggering arrangement of claim 1, wherein:
said first characteristic is the longest period between recurrences of said predetermined event or the shortest period between recurrences of said predetermined event.

7. The digital triggering arrangement of claim 6, wherein:
said first characteristic is continually updated to dynamically react to changes in said received signal in response to detection of different criteria for a characteristic of repetition as said received signal changes.

8. A method for improved triggering in a test and measurement instrument, comprising the steps of:
receiving a signal under test;
recognizing each occurrence of a predetermined event in said signal under test, and generating a signal indicative of all of said occurrences in said received signal under test, said predetermined event being a positive-going edge, a negative-going edge, a runt, a pulse width having a duration longer than a predetermined time, or a pulse width having a duration shorter than a predetermined time;
measuring a first characteristic of said received signal under test, said first characteristic being indicative of repetition of said received signal under test;
comparing said first characteristic against a second characteristic, said second characteristic being a subsequent occurrence of said first characteristic; and
generating a qualified trigger signal when said comparison circuitry indicates that said second characteristic is within a predetermined tolerance of said first characteristic, and inhibiting generation of said qualified trigger signal when said comparison indicates that said second characteristic is not within a predetermined tolerance of said first characteristic.

9. The method of claim 8, wherein:
said first characteristic is the longest period between recurrences of a predetermined event.

10. The method of claim 9, wherein:
said first characteristic is continually updated to dynamically react to changes in said received signal in response to detection of different criteria for a characteristic of repetition as said received signal changes.

11. The method of claim 8, wherein:
said first characteristic is the shortest period between recurrences of a predetermined event.

12. The method of claim 11, wherein:
said first characteristic is continually updated to dynamically react to changes in said received signal in response to detection of different criteria for a characteristic of repetition as said received signal changes.

13. The method of claim 8, wherein:
said first characteristic is the longest period between recurrences of a predetermined event or the shortest period between recurrences of said predetermined event.

14. The method of claim 13, wherein:
said first characteristic is continually updated to dynamically react to changes in said received signal in response to detection of different criteria for a characteristic of repetition as said received signal changes.
